# EUROPEAN PATENT SPECIFICATION

(11) **EP 2 784 799 B1**
(45) Date of publication and mention of the grant of the patent: **21.12.2022**
(21) Application number: 13161596.5
(22) Date of filing: 28.03.2013
(51) Int. Cl.: H01J 37/34, C23C 14/06, C23C 14/08, C23C 14/34, C23C 14/35

(54) **Dense, hard coatings on substrates using HIPIMS**
Dichte, harte Beschichtungen von Substrate durch HIPIMS
Revêtements denses et durs de substrats par pulvérisation magnétron pulsé à haute puissance

(43) Date of publication of application: 01.10.2014
(73) Proprietor: CemeCon AG, 52146 Würselen (DE)
(72) Inventor: Greene, Joseph, Jackson, Wyoming 83001 (US); Petrov, Ivan, New York, NY 10040 (US); Greczynski, Grzegorz, 58334 Linköping (SE); Hultman, Lars, 58931 Linköping (SE); Kölker, Werner, 52134 Herzogenrath (DE); Bolz, Stephan, 52066 Aachen (DE)
(74) Representative: Kalkoff & Partner Patentanwälte mbB

(56) References cited:
- WO-A2-2013/045454
- HONES P ET AL: "Mechanical properties of hard chromium tungsten nitride coatings", SURFACE AND COATINGS TECHNOLOGY, ELSEVIER, AMSTERDAM, NL, vol. 125, no. 1-3, 28 February 2000 (2000-02-28), pages 179-184, XP027328817, ISSN: 0257-8972 [retrieved on 2000-03-01]
- GRECZYNSKI GRZEGORZ ET AL: "Metal versus rare-gas ion irradiation during TiAlN film growth by hybrid high power pulsed magnetron/dc magnetron co-sputtering using synchronized pulsed substrate bias", JOURNAL OF VACUUM SCIENCE AND TECHNOLOGY: PART A, AVS /AIP, MELVILLE, NY., US, vol. 30, no. 6, 7 September 2012 (2012-09-07), pages 61504-61504, XP012160537, ISSN: 0734-2101, DOI: 10.1116/1.4750485 [retrieved on 2012-09-07]

## Description

The invention relates to coating of substrate by means of a physical vapor deposition (PVD) process, in particular by magnetron sputtering. More specifically, the invention relates to a process and device for coating a substrate as well as to a coated body.

In the field of PVD coating, known processes and devices for cathode sputtering provide cathodes with sputtering targets in a vacuum chamber. A plasma is generated by supplying electrical power to the cathodes, so that the targets are sputtered by ions. The sputtered material from the sputtering targets is deposited as a coating on a substrate arranged within the vacuum chamber.

For cathode sputtering, the electrical power may be supplied to the electrodes in different ways, for example as DC electrical power. It is also known to supply AC electrical power, in particular in the high frequency (HF) range. The electrical power may be supplied to the electrodes constant over time or varying. In particular, it is known to provide the electrical power in unipolar or bipolar pulses.

Recently, a sputtering process has been proposed referred to as HIPIMS (high power impulse magnetron sputtering). According to the HIPIMS process, electrical power is supplied in very short, yet extremely powerful pulses. During the resulting discharge, high current densities are reached at the targets. These pulses are supplied with relatively low duty cycle, i.e. a relatively long time period between pulses, so that the time average power is in the same range as in common DC sputtering processes.

US 2009/0068450 describes a method and an apparatus for multi-cathode PVD coating of substrates, where within a process chamber a number of magnetron cathodes are arranged. One cathode is operated according to HIPIMS, while another one of the cathodes is operated as an UBM (unbalanced magnetron) cathode. The coating materials for HIPIMS and UBM are different. In an example, CrN is deposited with HIPIMS, while TiN or NbN is deposited simultaneously by UBM. UBM can also be used to sputter multi-component materials such as TiAl, TiAlY, CrAl, ZrAl or pure graphite, so that layer sequences such as CrN/TiAlN, TiN/CrAlN or W/C are created.

The article "Matal versus rare-gas ion irradiation during TiAlN film growth by hybrid high power pulsed magnetron/dc magnetron co-sputtering using synchronized pulsed substrate bias" by Greczynski et al, Journal of Vaccuum Science and Technology, Part A, AVS/ AIP, Melville, N.Y., US, Vol. 30, no.6, 7 September 2012, pages 61504-61504, XP 012160537, describes the deposition of Ti₁₋ₓAlₓN films in NaCl structure on Si substrates by combining high-power pulsed magnetron sputtering (HIPIMS) and DC magnetron sputtering (DCMS). An Al target is powered in HIMPS mode, while a Ti target is operated as a conventional DC magnetron at an average power of 2.4 kW. Ti₁₋ₓAlₓN layers are deposited with three different biasing schemes, namely continuous bias, bias synchronously during the full 200µs HIPIMS pulse with (with the substrate at floating potential in between pulses) and with bias synchronized with the 60µs metal-rich-plasma portion of the HIPIMS pulse beginning at 40µs after pulse initiation. Layers deposited with continuous bias exhibit large compressive stress of -3.4 GPa. Layers deposited with synchronized bias exhibit a stress value of -0.2 GPa, and layers deposited with bias synchronized only to the metal-rich plasma portion have 0.5 GPa. Operating the Ti target by HIPIMS and the Al target by DCMS leads to high defect densities causing nucleation of wurzite-structure AlN second-phase precipitates.

It is an object of the present invention to propose a process and a device for coating a substrate, as well as a coated body, providing a particularly dense and hard coating.

This object is solved by a process according to claim 1 and a device according to claim 9. Dependent claims refer to preferred embodiments of the invention.

The present inventors have in particular analyzed hybrid coating methods and devices which use a combination of HIPIMS and, simultaneously and within the same processing chamber, conventional magnetron sputtering processes. While for such conventional sputtering a DC power supply will be most commonly used, the skilled person will understand that such conventional magnetron sputtering may alternatively also refer to methods and devices where electrical power is supplied to a magnetron sputtering cathode in time-variable manner, e. g. as AC electrical power, HF, or in (conventional) pulsed manner, e. g. as unipolar or bipolar pulses.

In the process and device according to the invention, at least two magnetron cathodes are provided in a vacuum chamber, in particular preferred as unbalanced magnetron cathodes, i.e. with an unbalanced magnet system as known per se in the art. A first cathode is provided with a sputtering target of a first material composition and a second cathode is provided with a sputtering target of a second material composition. Optionally, as will be explained below, further electrodes and targets with the same or different metal compositions maybe present within the vacuum chamber.

The cathodes are supplied with electrical power to form a plasma where the targets are sputtered. A substrate is arranged in the vacuum chamber such that particles from the plasma deposit onto the substrate forming a coating.

During the coating process, the first and second cathodes are operated differently. The first cathode is operated with pulsed electrical power according to high power impulse magnetron sputtering (HIPIMS). The electrical power is preferably supplied in pulses of a frequency of 50 - 1000 Hz, further preferred 80 - 250 Hz. A pulse duration is preferably short, such as less than 300 µs, preferably 150 - 250 µs. During the pulses, a peak current density at the first target is preferably higher than 0.12 A/cm², further preferably higher than 0.24 A/cm², most preferably higher than 0.36 A/cm².

The electrical power supplied to the second electrode may be supplied as in conventional magnetron sputtering, e.g. as DC electrical power, as HF electrical power, or as pulsed electrical power below the HIPIMS range. However, in any case the first peak current density applied to the first electrode during the HIPIMS pulses is higher than the second current density in the case of DC power, or second peak current density in the case of pulsed or otherwise time-variable electrical power, supplied to the second electrode. In the case of pulsed electrical power, the second peak current density is measured as the maximum reached during the pulses.

According to the invention, the first and second material compositions, i. e. the target materials of the first (HIPIMS) magnetron cathode and of at least the second (conventional) magnetron cathode are specifically chosen to be different to obtain an advantageous effect:
The sputtering target of the first cathode consists of a first material composition. The first material composition comprises a predominant metal element, which in the present context is referred to as a "processing metal element" because, as will be explained, the specific properties of the processing metal element will be used during deposition to alter the structure of the deposited coating.

The processing metal element is selected out of the group comprising Hf, Ta, W, Zr, Nb and Mo. These metals each have a relatively high atomic mass, which is advantageously used to provide, during the deposition process, correspondingly strong impacts onto the coating forming on the substrate.

It should be understood that within the first material composition the processing metal element need not necessarily be present in elemental form, and that the first material composition as such need not necessarily be metallic. It is within the scope of the present invention that the first material composition comprises, besides the processing metal element, other constituents, metallic and/or non-metallic. For example, the first material composition may be a metal alloy comprising, besides the predominant processing metal element, other metal constituents. As a further example, the first material composition may be ceramic, such as WC comprising as predominant metal element the processing metal element W.

In the present context, the term "predominant" is understood such that among the elements present in a material composition, the predominant element provides the highest atomic percentage (at.-%). Consequently, the term "predominant metal element" is understood such that the predominant metal element has the highest atomic percentage only among the metallic elements, i. e. disregarding the non-metallic elements. It is further preferred that the predominant element is not only relatively predominant in relation to the other elements, but even absolutely predominant, i. e. have an atomic percentage of above 50 at %. In the case of targets comprising more than one metal, it is generally possible that the targets may be provided homogeneously, e. g. as a uniform material, e.g. a compound or alloy including other metals, besides the predominant component. It is preferred to provide targets comprising more than a single metal as plug targets, i.e. one metal as plugs inserted into a plate of the other metal.

It is preferred that the first material composition comprises, among the metal elements thereof, more than 66 at.-% of the processing metal element, further preferred more that 90 at.-%, even further preferred more than 90 at.-%. In particular, it is preferred to provide the first material composition as the processing metal element in pure form (except for unavoidable contaminations, which will generally comprise less than 3 at.-%).

A second material composition is provided as the sputtering target of the second cathode, or - in the case of more than one cathode operated conventionally - the second material composition may be provided in combination by several sputtering targets. The second material composition is different from the first material composition and comprises predominantly carbon or one or more metals with a lower atomic mass than the processing metal element.

(In the present context half metal Si is understood as possible metal elements of the second material composition.) As will be further explained below, the second material composition comprises elements that have lower atomic weight than the processing metal element, namely C, Ti, Cr, Al, and Si.

Thus, it is proposed according to the invention to provide the HIPIMS target with a different material than the second (conventional) target, where the material of the HIPIMS target predominantly comprises the processing metal element with relatively high atomic mass, whereas the conventionally sputtered second target comprises materials with comparatively lower atomic mass. This specific constellation has proven to be highly advantageous for obtaining dense, hard coatings.

The reason for these improvements is the function of the relatively heavy atoms of the processing metal element during deposition. Ions of the processing metal element generated in a large number during each HIPIMS pulse are drawn towards the substrate by a bias voltage applied, as will be explained below. Bombardment with heavy ions of the processing metal element onto a film deposited mainly of the lighter atoms of the second material composition sets in motion a large number of recoils of the lighter atoms, which will generally be the dominant components of the deposited layers (due to the generally higher deposition rates of conventional magnetron sputtering). The recoiled atoms then have high-enough range to form a dense film, while the heavy metal atoms of the first processing metal element are incorporated in the coating layers without causing lattice distortion.

According to the invention, a bias voltage is applied to the substrates; in particular a negative voltage to render the substrates negative relative to the plasma potential in order to attract positively charged ions from the plasma. According to the invention, the bias voltage comprises voltage pulses which in the following will be referred to as bias pulses. During the bias pulses, the bias voltage will be higher than in between the bias pulses. According to the aspect of claim 9, the bias voltage during the bias pulses has an absolute value of 60 - 200 V as will be discussed below.

The values of the bias voltage mentioned in the present context are given as absolute values of the voltage between the substrate and an anode, while the polarity should be understood such that the substrate is negative with regard to an anode, which may e.g. be a separate anode or the chamber wall. In between the bias pulses, the substrate is connected to a fixed bias voltage value, which corresponds to a low DC voltage of up to 80V, which maybe e.g. less than 60V, preferably less than 40V. A lower limit for a DC bias voltage between pulses is as low as 10 V, preferably 20 V.

According to the aspect of claim 9, the bias voltage V_{B} during the bias pulses has an absolute value in the general range of 60 - 200 V. The inventors have found that the hardness of the deposited films increases with increasing V_{B}, but at higher values of more than 120 V the increase in hardness becomes smaller while residual stress increases. Thus, preferred absolute values for the bias voltage V_{B} during pulses are 80- 160 V, especially preferred 80-120 V.

According to the invention, the bias pulses are synchronized with the HIPIMS pulses applied to the first electrode. In the present context, "synchronized" refers to pulses appearing with the same frequency and a fixed phase relation. According to an aspect of the invention, the bias pulses are applied for a shorter pulse duration than the HIPIMS pulses applied to the first cathode. In particular, the bias pulses may be applied synchronized, but with a delay relative to the HIPIMS pulses, i. e. to start with a delay time after the start of the HIPIMS pulses.

The present inventors have found that during the application of HIPIMS-pulses to the first electrode, the metal ions within the plasma do not appear instantaneously after the application of the pulse, but that such metal ions are generated with a delay, such that a metal-ion rich period of each HIPIMS-pulse may be identified, during which the plasma comprises a substantial amount of metal ions, in particular more metal ions than gas ions (e.g. Ar⁺).

It is therefore preferred to apply the bias pulses such that an increased bias voltage is present during at least a part of the metal-ion rich period, and further preferred such that the bias pulses are applied substantially only during the metal-ion rich period, such that no or only a small part (e.g. 10% or less) of the bias pulse duration is present outside of the metal-ion rich period. If a continuously high DC bias is applied, or if a pulsed high bias with longer pulses, e.g. applied fully synchronously with the HIPIMS pulses at the first electrode, are applied, an increased amount of incorporation of the process gas, such as Ar, has been found in the resulting film.

In contrast, if the bias voltage V_{B} is applied in pulses synchronized mainly to the metal-ion rich period of each pulse, the amount of trapped process gas is significantly less and a dense
columnar microstructure coating is deposited with less compressive stress and a higher deposition rate because of less resputtering.

In consequence, it is proposed to apply bias pulses only with a delay after the start of the HIPIMS-pulses at the first electrode, such as after an initial period of e.g. 20 - 120 µs, preferably 40 - 100 µs, especially preferred 60 - 100 µs. It is further preferred, that the bias pulses are applied for 10 - 90 % of the pulse duration of the HIPIMS-pulses at the first electrode. For the purposes of this comparison, the pulse duration of the HIPIMS pulses maybe defined as the duration during which the current is above a value of 5% of the maximum current value of the pulse. Compared with this duration, the bias pulses may be applied with a shorter duration of preferably 30-70%, especially preferred 40-60%. By choosing a synchronization between the bias pulses and the HIPIMS pulses within thus defined limits, films with preferred properties such as high hardness and very low process gas incorporation may be deposited.

Due to the effect of the ions of the metal processing element, it is possible to form hard and dense layers at substantially reduced process temperature as compared to prior conventional coating processes by magnetron sputtering. During the deposition process, the temperature of the substrate is kept at less than 450° C. In particular, it is possible to keep the substrate temperature at less than 300° C, and further preferred even at less than 200° C. The process may be conducted without external heating.

Advantageously, the synchronized bias pulses may be applied together with specially applied, namely "cut" HIPIMS pulses. In these pulses, the pulse duration is shortened. In one embodiment, the cathode power is cut off near to or preferably at the peak current. This serves to achieve better coating properties and to avoid self-sputtering and back-sputtering which leads to a lower deposition rate.

By simultaneous operation of the first, HIPIMS cathode for generating ions of one or more of the heavy processing metal elements and of the second cathode delivering by conventional sputtering the remaining, and generally predominant materials of the coating layer forming on the substrate, particularly dense and hard coatings may be obtained. In particular, it is preferred that the second material composition of the second target comprises one or more of C, Ti, Cr, Al, and Si. It is generally known to deposit layers out of these target materials, in particular in reactive sputtering. By using the compacting effect, discovered by the present inventors, that occurs through bombardment with ions of the relatively heavy processing metal element on the layer formed predominantly out of the second material composition from the second target, the structure and layer properties may be significantly improved.

As generally known in the art, a process gas such as argon or krypton is supplied to the vacuum chamber to deliver ions used for sputtering. Further, a reactive gas is supplied to the vacuum chamber which comprises nitrogen, further preferred consists of nitrogen.

In configurations with more than two cathodes, i.e. where besides the first (HIPIMS) cathode and the second (conventionally operated) cathode at least one further cathode is provided which is also operated conventionally, i.e. either by DC power with a constant current density below the first peak current density or by time variable electrical power with a peak current density below the first peak current density, the materials forming the second material composition may be provided in combination by the material of the targets of the conventional cathodes. Thus, e.g. for a nitride layer consisting of titanium and aluminum, densified by tantalum, the second material composition will consist of aluminum and titanium, but not every one of the conventionally operated targets need necessarily be equipped with a target material comprising both aluminum and titanium. In fact, the same second material composition may be provided e.g. by two DC cathodes, each equipped with a combined titanium / aluminum plug target, or by one DC cathode with a titanium target and another DC cathode with an aluminum target. The skilled person will understand that the same applies for all second material compositions in the case of more than one conventional cathode. Thus, as in the following embodiments preferred examples of second material compositions are explained, the skilled person will understand that these maybe obtained in combination by at least two targets of different material, attached to conventional cathodes.

In preferred embodiments of the invention, the second material composition is comprised - except for unavoidable contaminations, which will generally be below 3 at.-% - of either titanium, or chromium, or of a combination of chromium and aluminum, or a combination of titanium and aluminum, or of a combination of titanium, chromium and aluminum. These materials are preferably deposited in reactive sputtering as nitrides. The preferred processing metal element for these material systems is Ta. The resulting coating layers, in particular TiTaN, CrTaN, CrAlTaN, TiAlTaN and TiCrAlTaN (or, substituting for Ta, another one of the preferred processing metal elements) may advantageously be used as hard coatings on tools, in particular on machining tools for steel machining.

In other preferred embodiments, the second material composition is comprised out of titanium and boron, or titanium and silicon, or titanium, aluminum and silicon, or titanium, chromium, aluminum and silicon, or chromium and silicon.

Again, the layers are preferably deposited as nitrides and the preferred processing metal element is Ta. Such layers are in particular suited for machining tools for purposes where high machining temperatures occur, in particular for machining hard materials such as materials with more than 50 HRC, titanium alloys, nickel base alloys, stainless steel or spheroide graphite iron.

In a further preferred embodiment, tribological layers may be formed by a second material composition comprising carbon, in particular consisting of carbon, except for unavoidable contaminations. In this case, the preferred processing metal element is W.

In different embodiments of the invention, further electrodes may be provided in the vacuum chamber. Further cathodes may be provided with the same configuration as the first and second cathode, i.e. with the same type of electrical power supply, and with the same target configuration. In this case, the additional cathodes serve for increasing the batch size, i.e. provide, within a single vacuum chamber, a larger amount of the target material, so that a larger substrate surface may be coated.

Alternatively or in addition, further cathodes may be provided in the vacuum chamber with a configuration differing from both the first and the second cathode. For example, at least a third cathode may be provided with a sputtering target of different material. The third cathode may be operated either conventionally or with HIPIMS.

According to further preferred embodiments, substrate bodies are arranged to be moved within the vacuum chamber during deposition. In particular, substrate bodies may be arranged on a rotating support.

A coated body which may be manufactured with the process and device according to the invention comprises a substrate and at least one coating layer, which may advantageously be produced by the above described method and device. The coating layer provided on a substrate, such as a tool, made e. g. from high-speed-steel or cemented carbide, maybe a single coating layer. Alternatively, the coating layer may be one of a plurality of coating layers, e. g. in a multilayer configuration.

The coating layer comprises nitrides, or oxynitrides of C, Ti, Cr, Al, Si or a mixture thereof. The coating layer further comprises at least one of the processing metal elements Hf, Ta, W, Zr, Nd and Mo. The coating layer predominantly consists of the above layer materials, while the processing metal element is only present in relatively small atomic concentration of 1 - 18 at.-%. Further preferred is an atomic concentration of 6 - 13 at.-%, especially preferred 7-9at.-%.

The coating layer may comprise an exceptionally low process gas concentration of only 0.3 at.-% or even less, in particular an argon concentration of 0.3 at.-% or less. This is made possible, as described above, by a bias voltage comprising bias pulses synchronized to the metal-rich ion period of HIPIMS pulses.

In preferred embodiments, the layer further has high hardness of at least 20 GPa. Further, the coating layer may preferably have very low residual stress, particularly preferred residual stress with an absolute value below 0.3 GPa. This is also made possible by the above described device and method, where the high hardness is obtained by the advantageous layer structure caused by impulse bombardment with the heavy metal ions of the processing metal element, and where the amount of incorporation of ions of the process gas is significantly reduced by the synchronized bias pulses.

In the following, embodiments of the invention will be discussed with relation to the figures.

In the figures,
- fig. 1: shows a schematic representation of a first embodiment of a coating device,
- fig. 2: shows schematically a coating layer on a substrate,
- figs. 3, 4: show diagrams illustrating a pulsed bias voltage over time,
- fig. 5: shows a diagram illustrating the hardness as a function of the bias voltage,
- fig. 6: shows residual stress as a function of substrate bias voltage,
- fig. 7: shows an XTEM image of a deposited layer,
- figs. 8, 9: show alternative embodiments of coating devices.

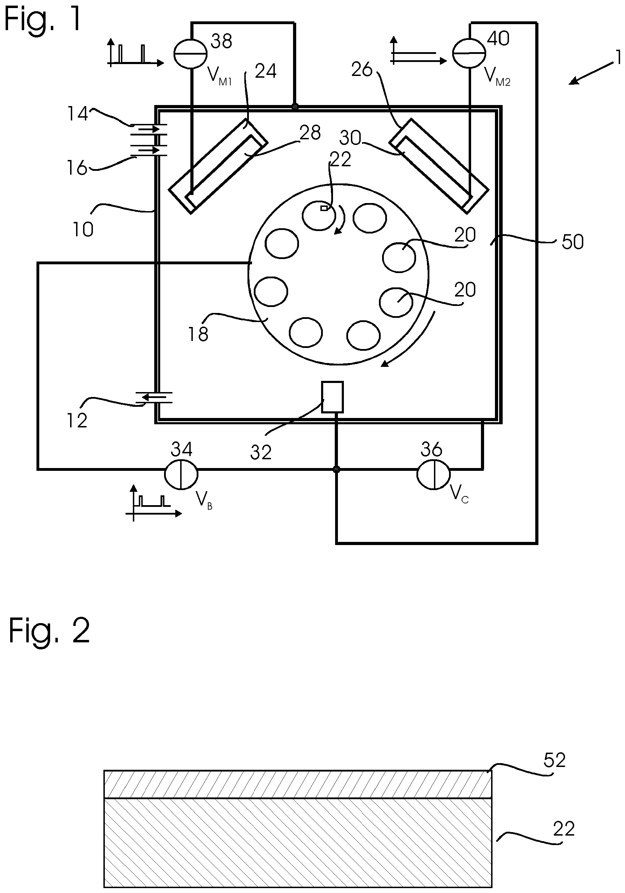

Fig. 1 shows schematically a PVD sputter coating device 1 in a top view including a vacuum chamber 10 comprising a vacuum system 12 for providing a vacuum on the inside of an electrically conductive chamber wall 50 and inlets 14, 16 for a sputtering gas (preferably argon) and a reactive gas comprising nitrogen.

. Within the vacuum chamber 10, a rotatable substrate table 18 with planetary rotating supports 20 is arranged. Substrate work pieces 22 of which only one is shown in fig. 1, are arranged on the supports 20.

Further arranged within the vacuum chamber 10 next to the rotating table 18 are magnetron cathodes 26, 24. Each magnetron cathode 24, 26 comprises an unbalanced magnet system as known per se in the prior art. First magnetron cathode 24 comprises a flat rectangular sputtering target 28. A second magnetron cathode 26 comprises a sputtering target 30. Within the vacuum chamber 10, an anode 32 is arranged. The anode 32 is electrically connected to different electrical power supplies. A bias power supply 34 for delivering a bias voltage V_{B} is connected between the anode 32 and the substrate table 18, which is electrically conductive, such that the bias power supply 34 is also electrically connected to the individual substrate work pieces 22. The bias voltage V_{B} is negative, i.e. sets the substrate potential to a negative value to attract positively charged ions.

A chamber wall power supply 36 is connected between the anode 32 and the electrically conductive chamber wall 50 of the vacuum chamber 10, delivering a voltage Vc.

A first magnetron power supply 38 delivering a first magnetron voltage V_{M1} is connected between the first magnetron cathode 24 and the chamber wall 50. A second magnetron power supply 40 delivering a second magnetron voltage V_{M2} is connected between the anode 32 and the second magnetron cathode 26. As will be explained below, the first power supply 38 is a HIPIMS supply, delivering electrical power in short pulses. The HIPIMS magnetron cathode 24 and the corresponding HIPIMS power supply 38 are configured and driven as explained in WO 2009/132822 A2.

The second power supply 40 is a conventional DC power supply. The power supplies 38, 40 deliver a negative voltage to the cathodes 24, 26, relative to the anode 32.

In operation of the coating device, substrates 22 are loaded onto the rotating supports 20. A vacuum is generated within the vacuum chamber 10. Argon as a sputtering gas is supplied through the inlet 14. Electrical power is applied by power supplies 38, 40 to the magnetron cathodes 24, 26 to generate a plasma within the vacuum chamber 10.

Ions from the plasma sputter the sputtering target 28, 30. By applying a negative bias voltage V_{B} comprising bias pulses as will be described in more detail below, ions from the plasma are urged onto the surface of the substrates 22 for depositing a layer. During the deposition process, nitrogen is supplied through the inlet 16 as a reactive gas.

In the coating device shown in fig. 1, the first and second magnetron cathodes 24, 26 differ both by the composition of their respective targets 28, 30 and the electrical power supplied by the corresponding power supplies 38, 40. The first magnetron cathode 24 is equipped with a target 28 of a first material composition including as "processing metal element" a metal with high atomic mass, namely Hf, Ta, W, Zr, Nb or Mo.

The target 28 in a first example is a pure Ta target. Electrical power supply 38 supplies voltage V_{M1} in pulses according to HIPIMS, i.e. very short pulses leading to a discharge with an extremely high current density at the target 28.

The second target 26 is equipped with a second material composition comprising elements of lower atomic mass, namely C, Ti, Cr, Al or Si.

In the first example, the second target 26 is a pure Ti target 30. Electrical power is supplied to the second magnetron cathode 26 as a DC voltage V_{M1}. In operation of the device 1, a layer is deposited on the substrate 22. Fig. 2 schematically shows a coating layer 52 on the substrate 22. The composition and structure of the layer 52 is dependent on the material of the targets 28, 30, the process gas and reactive gas supplied at inlets 14, 16 and on the operating parameters, in particular of the power supplies 38, 40 to the magnetron cathodes 24, 26 and of the bias voltage supply 34.

In operation of the device 1, conventional magnetron sputtering, here preferably direct current magnetron sputtering (DCMS) and high power pulsed magnetron sputtering (HIPIMS) are combined to deposit thin films such as the layer 52. In the first example, the Ti target 30 is operated in DCMS mode leading to the generation of a plasma within the chamber 10 such that the target 30 is sputtered. The plasma constituents deposit on the substrates 22 as layer 52. Simultaneously, the first cathode 24 with the Ta target 28 is operated in HIPIMS mode, such that the Ta target 28 is sputtered and during the periodic high pulses large amounts of ionized Ta⁺/Ta²⁺ ions are generated. These Ta ions will, due to the bias voltage V_{B}, the details of which are described below, be drawn towards the substrate 22 and the film 52 growing thereon and effect an impulse bombardment.

Due to the high atomic mass of Ta as compared to the considerably smaller mass of Ti, the resulting impulse bombardment with heavy metal ions achieves a densification of the deposited film 52. The underlying idea is that the heavy metal ions (Ta in this first, preferred example, but Hf, W, Zr, Nb, or Mo may be used alternatively) sets in motion a large number of recoils of the lighter atoms which are the dominant component of the growing film 52. The recoiled atoms than have high-enough range to form a dense film, while the heavy metal atoms get incorporated in the films without causing lattice distortion.

This process maintains the high deposition rates of conventional magnetron sputtering, while obtaining coating layers 52 with advantageous properties, such as a dense structure without voids and pores.

The bias voltage V_{B} applied between the anode 32 and the substrates 22 onto which the layer 52 is deposited, is applied as a DC bias offset voltage with superimposed bias pulses 63. As the inventors have found, the structure and properties of deposited layers 52 may be influenced significantly by the synchronization of a pulsed bias voltage V_{B} with the HIPIMS pulses applied to the first magnetron cathode 24.

In an analysis of ions present in the plasma after an HIPIMS pulse, the present inventors have found that different ions are present at different times. For an HIPIMS pulse started at t = o µs by applying the voltage pulse V_{M1} to the first cathode 24, distinguished phases may be defined. In an initial period, directly after the start of the pulse, the ions in the plasma at the position of the substrates are dominated by ions of the process gas, i. e. in an example Ar⁺ ions with relatively low contribution from metal ions. The initial period may, in the preferred case of a Ta target, have a duration of. e.g. 80µs. In a following time period, referred to as a metal-ion rich period, the plasma is dominated by metal ions. In the preferred case of a Ta target, this period has been identified to start at about 80µs after the start of the HIPIMS pulse and end approximately together with the pulse at about 200µs after the start of the HIPIMS pulse. One possible definition of the boundary between the initial period and the metal-ion rich period could be that in the initial period the amount of gas ions is higher than the amount of metal ions, while the proportion is reversed in the metal-ion rich period, where the intensity of gas ions is reduced due to rarefaction.

Thus, within the different periods over time within each HIPIMS-pulse, different types of ions are present. For a bias voltage V_{B} applied continuously as a DC voltage, or for a pulsed bias voltage V_{B} fully synchronized with the HIPIMS-pulse, i.e. appearing from the start thereof at t = o µs, process gas ions generated in a large number in the initial period will act on the substrate 22. However, by providing a pulsed bias voltage V_{B} synchronized only with the metal-ion rich period, it is possible to specifically select the metal ions from the plasma to act on the growing layer 52.

By delaying the bias pulses 63 with respect to the HIPIMS pulses, and thus avoiding the initial period and achieving a synchronization with the metal-ion rich period, where metal ions dominate, it is possible to minimize effects caused by ions of the process gas, in the present case Ar.

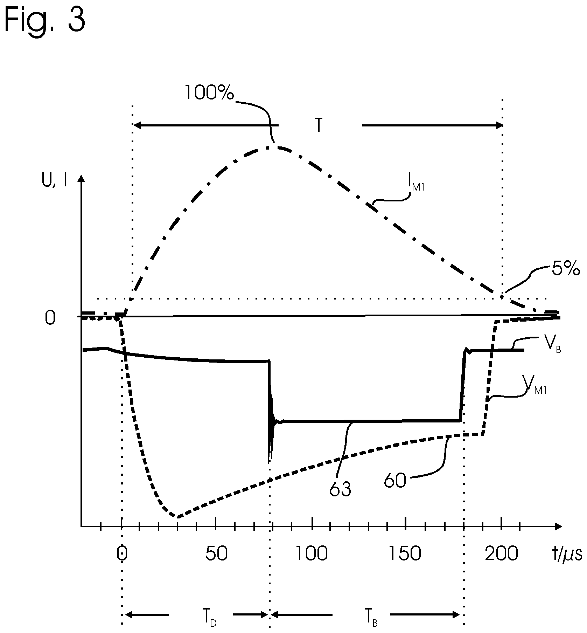

Fig. 3 shows, for an example of a single HIPIMS pulse 60 supplied to the first cathode 24, an example of curves for the voltage V_{M1}, the current at the first cathode 24 I_{M1} and a synchronized pulsed bias voltage V_{B} comprising a DC bias offset voltage and superimposed bias voltage pulses 63.

As will be appreciated by the skilled person, the magnitudes of the voltages V_{M1} and V_{B}, and of the current I_{M1} are not indicated in fig. 3. For the HIPIMS pulse 60, the voltage V_{M1} may rise up to a peak of about 2000 V, and the current I_{M1} may reach a peak (100%) of about 3000 A. The voltages V_{M1} and V_{B} are not shown on the same scale.

The pulsed voltage V_{M1} (HIPIMS pulse 60) is applied from t = 0 - 200 µs. The resulting current I_{M1} also shows a pulse behavior. The current pulse duration T, defined as the duration during which the current I_{M1} is above 5% of the maximum current value, is about 200 µs. In the example shown, the bias voltage V_{B} is applied as a DC bias offset voltage of 20 V with bias voltage pulses 63 of a duration T_{B}, where in the current example T_{B} = 100 µs, such that T_{B} is about 50% of T. The bias pulse is applied after a delay time T_{D}, which in the current example corresponds to 80 µs, i.e. about 40% of the pulse duration T.

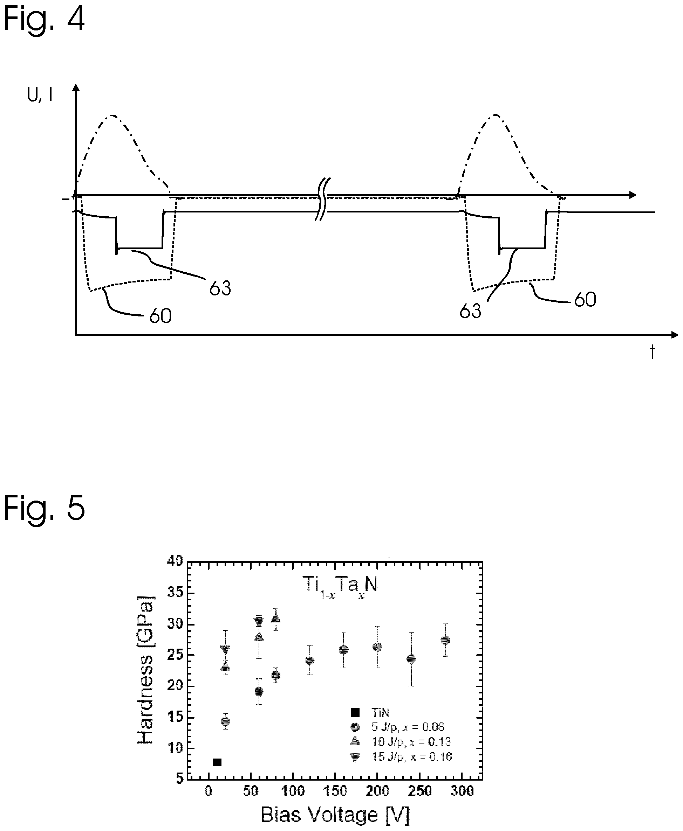

Fig. 4 shows how the bias pulses 63 are synchronized with each HIPIMS pulse 60. In the example shown, the HIPIMS pulses with a duration of about 200 µs appear with a frequency of 200 Hz, i.e. with an interval in between of about 4800 µs, i.e. with a duty cycle of about 4,17 %. Within each HIPIMS pulse interval, bias pulses 63 of the same duration of 100µs are applied with the same delay T_{D} of 80µs after the start of the pulse. Thus, the frequency of the bias pulses is the same as the frequency of the HIPIMS pulses, 200 Hz in the present example. The bias pulses, which are shorter in duration than the HIPIMS pulses, have a lower duty cycle of about 2.1%. In between the bias pulses, the DC bias offset voltage is applied.

The bias pulses 63 thus defined correspond to the metal-ion rich period. It will be appreciated by the skilled person that the synchronization need not be complete, i.e. acceptable results may be achieved already with a minor overlap with other periods.

In a comparison of a DC bias without bias pulses, a pulsed bias with bias pulses fully synchronous to the HIPIMS pulse 60, and the preferred bias pulse shown in fig. 3, limited to the metal-ion rich period, the films 52 deposited with the preferred, shorter bias pulse have a very low concentration of trapped Ar within the film, below the detection limit, whereas the DC bias and fully synchronous pulsed bias show a larger amount of Argon incorporated within the film. Further, resputtering is lower in the case of bias pulses 63 synchronized to the metal-ion rich period, so that deposition rates are increased.

It should be mentioned that the pulse shape of a HIPIMS pulse 60 as shown in fig. 3, 4 is only one example of such a pulse. In a HIPIMS power supply for a HIPIMS cathode, the pulse is preferably obtained by connecting a charged capacitor to the cathode, such that the capacitor discharges over the gap between cathode and anode. If the capacitor is fully discharged, a pulse shape as represented in fig. 3, 4 may occur.

However, the pulse shape may be modified. In particular, it may be preferred to reduce the time duration of the HIPIMS pulse. It is advantageous to cut off the pulse (i.e. disconnect the capacitor) after a specific period such as e.g. 200µs. This still allows to obtain the advantageous metal ion rich period 44, while avoiding a possible later period with a higher concentration of ions of the working gas. The "cut" (i.e. forcibly ended) pulse further has the advantage of less self sputtering at the HIPIMS cathode.

Particularly preferred is a combination of a synchronized bias pulse 63 and a cut, i.e. shortened HIPIMS pulse. The HIPIMS pulse, once the avalanche effect responsible for the rise of metal ions is working, succeeds to produce a cloud of ions in front of the HIPIMS cathode 24. A synchronized bias pulse 63 which starts with a delay after the start of the HIPMS pulse, and which is applied synchronously to the metal ion rich period succeeds to accelerate the ion cloud formed in front of the HIPIMS cathode 24 onto the substrate.

In the deposited layers 52, concentrations of ≤ 18 at.-% of the heavy processing metal element, which is at least part of the material of the target 28 of the HIPIMS cathode 24, were sufficient to achieve dense and hard coatings 52 with deposition rates retained at high values comparable to conventional magnetron sputtering. The concentration of the processing metal element within the layer 52 is dependent on the ratio of electrical power supplied to the conventional cathode(s) and to the HIPIMS cathode(s) respectively.

It has further been found that due to the impulse bombardment with the heavy metal ions of the processing metal elements the processing temperature may be significantly reduced, while still obtaining dense films. In conventional PVD coating, ion-mixing and ion-bombardment induced surface adatom mobility has been used as the main tool to substitute for high-temperature driven diffusion in order to obtain dense films without voids and pores. There are two-primary approaches to achieving ion-assisted densification: the use of (i) inert and reactive gas ions and (ii) metal ions that are constituents of the films (e.g. ion beam deposition, ion beam sputter deposition, cathodic arc, HIPIMS etc; sometimes the latter technique is termed "energetic condensation"). In both cases, the progress achieved in lowering the deposition temperature comes at the price of incorporating compressive stress in the coatings with associated undesired effects and/or lower deposition rates in ion-beam systems. Inert and reactive gas ion bombardment results in trapped gas atoms occupying interstitial positions and thus increasing film compressive stress. Energetic condensation via HIPIMS and cathodic arc deposition also result in compressive stress and in addition the energy input to obtain dense films by itself is a significant source of heating resulting in temperatures above 450°C if high rate deposition is needed in industrial processes.

Due to the impulse bombardment with heavy metal ions of the processing metal element, dense, hard films may be and according to the invention are deposited at deposition temperatures (measured at the substrate) of below 450° C, in particular 300° C and even at less than 200° C.

In the first example of operation of the device 10 as shown in fig. 1, which is a CC800/9 magnetron sputtering system manufactured by CemeCon AG, the target 28 of the first (HIPIMS) cathode 24 entirely consists (except for unavoidable impurities) of Ta while the target 30 of the second (DC) cathode 28 entirely consists (except for unavoidable impurities) of Ti. The targets 28, 30 are provided as cast rectangular 8.8×50 cm² plates.

The Ti target 30 is operated in DCMS mode at an average power of 6 kW. The Ta target 28 is driven in HIPIMS mode thereby creating pulses of ionized Ta⁺/Ta²⁺ ions incident on the growing film surface with a frequency of 100 Hz. HIPIMS pulses are applied to be cut off (i.e. the capacitors were disconnected) after a pulse duration of 200µs. The average electrical power supplied to the HIPIMS target 28 is 6 kW, i.e. the same as the DC target 30. During each HIPIMS pulse, the peak current density over the surface of the HIPIMS target 28 is about 0.45 A/cm².

A substrate bias voltage V_{B} is applied including bias voltage pulses 63 synchronous with the Ta metal-rich-plasma portion of the HIPIMS pulses 60 beginning at 80 µs after pulse initiation and lasting up to 180 µs after pulse initiation. The substrate bias voltage V_{B} has a DC bias offset of 20 V; during the bias voltage pulses the bias voltage V_{B} is increased to 60 V_{B} 120 V, preferably 100V.

In a first example, no external heating is applied during the one-hour-long coating process. Substrate temperature monitored with the built-in thermocouple placed next to the substrate increases from 65-68 °C to 125-130 °C in the course of deposition.

The deposited layers 52 are Ti₁₋ₓTaₓN layers with x ≤ 0.18. In the above described first example, a Ti_{0.92}Ta_{0.08}N layer 52 is deposited. Despite low process temperature (< 130 °C) the Ti_{0.92}Ta_{0.08}N films 52 are dense and exhibit hardness H and modulus of elasticity E values typical of TiN films deposited by DCMS at 500 °C.

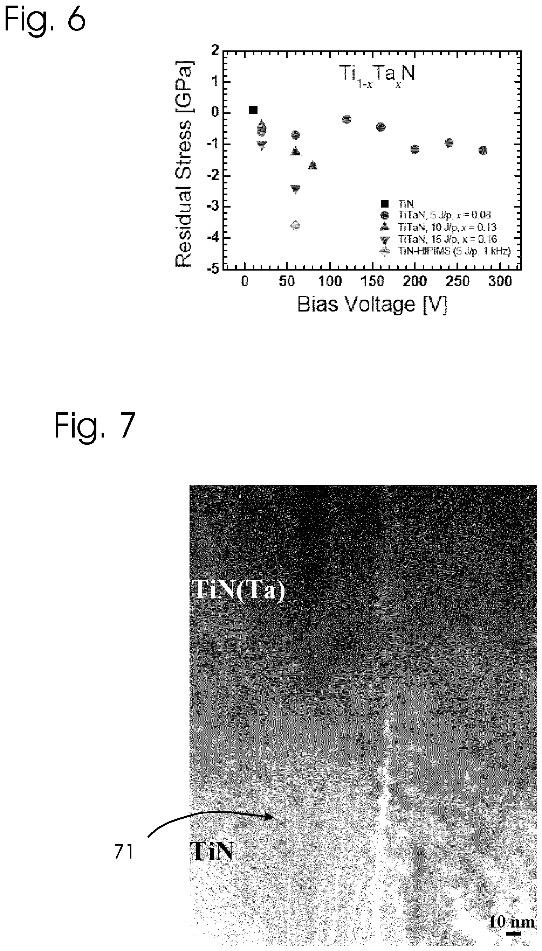

Fig. 7 shows an XTEM image illustrating the effect of Ta ion bombardment. The coating shown comprises, shown in the lower half of Fig. 7, first a TiN layer deposited by only operating the second cathode 26 with DC electrical power. Voids are found present in the TiN layer which in a region designated 71 in Fig. 7 exhibits faceted TiN columns with a large degree of intra-grain porosity. After a period of deposition of the TiN layer, further deposition was effected by simultaneously operating also the first cathode 24 by HIPIMS. As visible in the upper half of Fig. 7, the structure of the deposited layer changes, and any pores or voids in the layer structure are now closed up by the resulting Ta⁺ bombardment.

Figs. 5, 6 show, for examples of layers 52 deposited with different pulse energies, hardness and residual stress of the deposited layer in GPa as a function of bias voltage *V_{B}* during the bias voltage pulses 63.

In one example, the energy of the individual HIPIMS pulses is 5 Joule per pulse (circles in Fig. 5, 6), in another example 10 Joule per pulse (triangle pointing up in Fig. 5, 6) and in a further example 15 Joule/pulse (triangle pointing down in fig. 5,6). Dependent on the pulse energy, the amount of Ta within the layer 52 differs: In the first example, Ta is present in 8 at.-%, in the second example in 13 at.-% and in the third example in 16 at.-%.

As comparative examples, TiN deposited without HIPIMS is indicated in Fig. 5, 6 as a square.

As illustrated by Fig. 5, the hardness generally increases with increasing bias voltage.

For the films 52 deposited with 5 J / pulse and bias of 60 *V_{B}* 120 V, H is in the range 20-22 GPa and is a factor of three higher than for the reference TiN film (H = 7.7 GPa) deposited with no external heating and at the same average power of 6 kW. For higher pulse energies and higher Ta content, hardness is even higher from 23 up to 30 GPa.

As shown in Fig. 6, residual stress is low in particular for films deposited with 5 J/pulse. Thus, hard films with 8 at.-% Ta are obtained with very low residual stress.

For higher pulse energies and thus higher Ta content, hard films with low stress may be obtained by applying relatively low bias voltages of around 20 V. Even films deposited with 15 J/pulse which have 16at.-% Ta content deposited at 20 V bias voltage exhibit H around 25 GPa and residual stress at around -1 Gpa which is significantly lower than a corresponding TiN film deposited entirely by HIPIMS.

All films deposited with the synchronized bias pulses show very low argon incorporation below 0.3 at.-%.

Particularly preferred are thus examples with low Ta content of around 8 at.-%. The residual stress obtained from XRD sin²*ψ* analyses for Ti_{0.92}Ta_{0.08}N films is -0.2 GPa. The XPS depth profiles indicate high oxygen concentrations in the reference low temperature TiN films (8 at%) indicative of a porous microstructure. In contrast, corresponding analysis performed on the Ti_{0.92}Ta_{0.08}N films 52 show that the bulk oxygen content is less than 1 at%, i.e., within the uncertainty limits of this technique. Such low oxygen content indicates dense microstructure that results upon periodic Ta⁺/Ta²⁺ ion bombardment.

While the first embodiment of a coating device according to fig. 1 with no more than two electrodes may be used to produce the coating 52 on the substrate 22, it is preferred to provide more than two cathodes in devices for coating substrates 22 on an industrial scale.

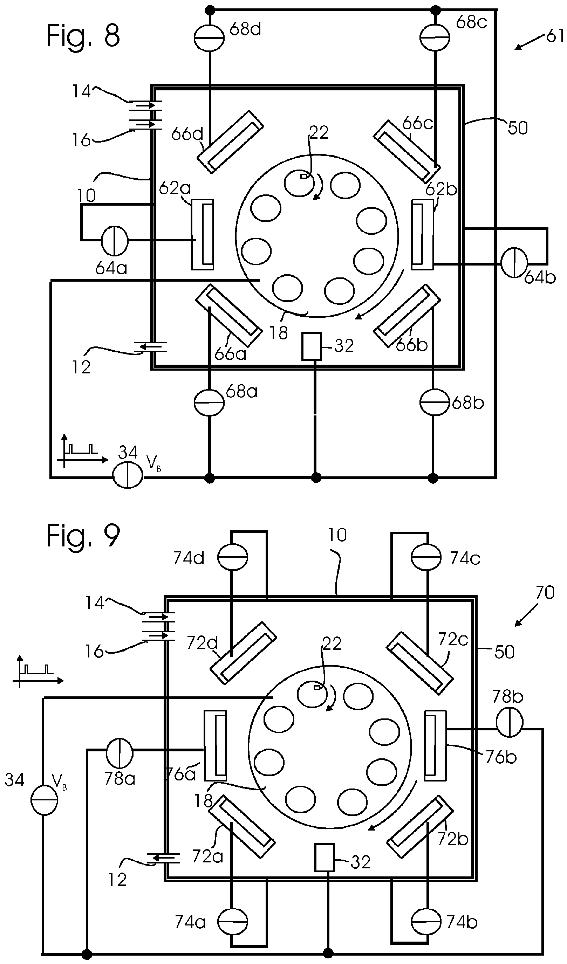

As a second embodiment, fig. 8 shows a coating device 61 corresponding to the coating device of fig. 1, but with a different electrode configuration. Likewise, fig. 9 shows a third embodiment. Except for the electrode configuration, i.e. type and arrangement of power supplies as well as targets provided at the cathodes, the coating devices of fig. 8 and 9 are identical to the first embodiment shown in fig. 1.

In the second embodiment according to fig. 8, four conventionally DC-powered magnetron cathodes 66a, 66b, 66c, 66d are provided within the chamber 10, each with a DC power supply 68a, 68b, 68c, 68d connected to the anode 32. Two HIPIMS cathodes 62a, 62b are provided, each with an HIPIMS power supply 64a, 64b connected to the chamber wall 50.

In the following, examples for target configurations in the embodiments of fig. 1 or fig. 8, and corresponding operation will be discussed.

In the cathode configuration of fig. 1 with only two cathodes 24, 26, the examples of target configurations given in Table 1 may e.g. be used for coating of tool substrates to produce machining tools for steel machining:

**Table 1:**

| Example No. | Material on first (HIPIMS) Target 28 | Material on second target 30 |
|---|---|---|
| 1 | Ta | Ti |
| 2 | Ta | TiAl |
| 3 | Ta | Cr |
| 4 | Ta | CrAl |
| 5 | Ta | TiCrAl |
| 6 | Ta | Al |
| 7 | w | Ti |
| 8 | w | CrAl |
| 9 | Hf | TiAl |
| 10 | Hf | CrAl |
| 11 | Zr | TiAl |
| 12 | Zr | Ti |
| 13 | Mo | TiAl |
| 14 | Mo | Ti |
| 15 | Nb | Ti |

For producing machining tools which may be used in machining applications which require high temperature resistance, the examples in Table 2 may e.g. be used:

**Table 2:**

| Example No. | Material on first (HIPIMS) Target 28 | Material on second target 30 |
|---|---|---|
| 16 | Ta | TiSi |
| 17 | Ta | TiAlSi |
| 18 | Ta | TiCrAlSi |
| 19 | Ta | CrSi |
| 20 | Ta | CrAlSi |
| 21 | Ta | AlSi |
| 22 | w | TiAlSi |
| 23 | Hf | CrAlSi |
| 24 | Zr | TiAlSi |
| 25 | Mo | CrAlSi |

For tribological applications, the examples from Table 3 may be used:

**Table 3**

| Example No. | Material on first (HIPIMS) Target 28 | Material on second target 30 |
|---|---|---|
| 26 | w | C |
| 27 | Ta | C |

In the cathode configuration of fig. 8 with four conventional cathodes 66a-d and two HIPIMS cathodes 62a, 62b, the following examples of target configurations from Table 4 may e.g. be used for coating of tool substrates for producing machining tools for steel machining:

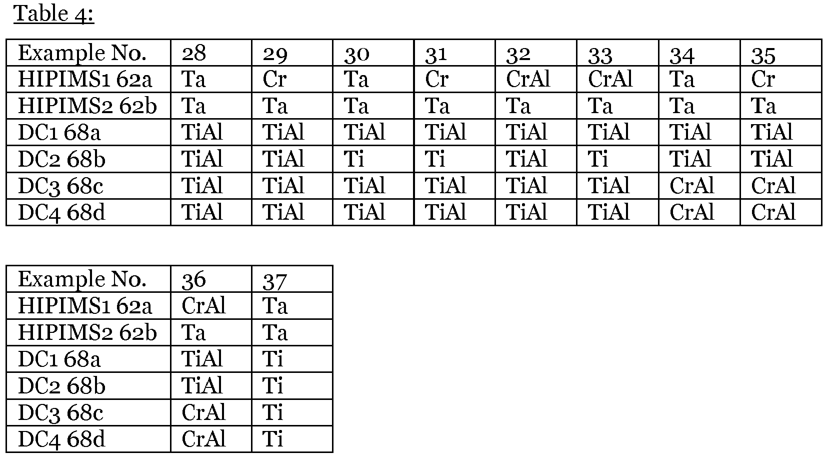

For producing machining tools usable in machining applications which require high temperature resistance, the examples from Table 5 may e.g. be used:

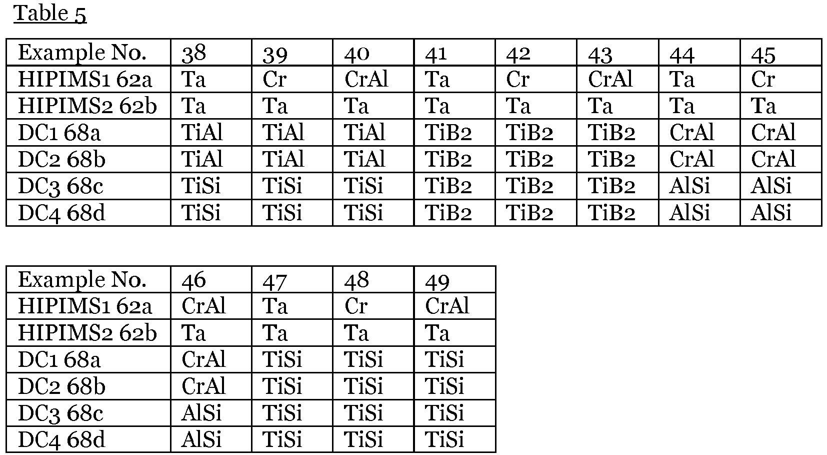

For tribological applications, the following examples from Table 6 may be used:

**Table 6:**

| Example No. | 50 | 51 | 52 |
|---|---|---|---|
| HIPIMS1 62a | W | Cr | W |
| HIPIMS2 62b | w | w | c |
| DC1 68a | C | C | C |
| DC2 68b | C | C | C |
| DC3 68c | C | C | C |
| DC4 68d | C | C | C |

As an exemplary embodiment, the coating procedure for example 29 will be explained in more details. As shown in the above table, the four conventional magnetron cathodes 66a - 66d are each equipped with Ti-Al targets, i.e. aluminum targets with A1 inserts in the shape of plugs. The first HIPIMS magnetron cathode 62a is equipped with a pure Ta target and the second HIPIMS cathode 62b is equipped with a pure Cr target.

In operation, first etching of the substrates 22 is performed by only using the second HIPIMS magnetron cathode 62b operated in HIPIMS mode while applying a high DC bias voltage. In the following coating process, all six cathodes are operated simultaneously.

During sputtering, Ar is supplied as process gas, and nitrogen as reactive gas. The resulting coating layer 52 is a TiAlCrTaN layer which shows high hardness and exceptionally low residual stress.

Coating procedures for the other examples may be effected accordingly.

Common between the preferred configurations is in each case that at least a first electrode is operated in HIPIMS mode and comprises a target with a first material composition in which, among the metal elements thereof, the processing metal element is predominant and has high atomic mass. In contrast, conventionally operated cathodes are equipped with targets comprising predominantly lighter elements.

In alternative configurations, further non-metal elements such as C, B, and/or O may be added, either as reactive gas (e.g. oxygen) or as constituents of the target material.

The above illustration and description of embodiments of the invention is to be considered illustrative or exemplary and not restrictive; the invention is not limited to the disclosed embodiments. The mere fact that certain measures are recited in mutually different embodiments does not indicate that a combination of these measured cannot be used to advantage.

For example, instead of using a separate anode 32 as in fig. 1, fig. 8 and fig. 9, the metallic chamber wall 50 may alternatively be used as anode for some or all of the cathodes. Thus, in an alternative configuration, the chamber wall power supply 36 may not be present. While it is preferred as shown in the embodiments to operate HIPIMS-cathodes 24 (in fig. 1), 62a, 62b (in fig. 8) and 74a-74d (in fig. 9) against the chamber wall 50 as anode, whereas non-HIPIMS-cathodes are operated against a dedicated anode 32, it is alternatively, also possible to operate HIPIMS-cathodes against a dedicated anode, and/or to operate non-HIPIMS-cathodes against the chamber wall 50.

## Claims

1. A process for coating a substrate (22), comprising
- providing at least two magnetron cathodes in a vacuum chamber (10),
- of which at least a first cathode (24) is provided with a sputtering target (28) of a first material composition,
- and where a second material composition is provided as the material of at least one sputtering target (30) at at least a second cathode (26), said second material composition predominantly comprising one or more of the elements chosen from the group consisting of C, Ti, Cr, Al, and Si, said one or more elements having a lower atomic mass than said processing metal element,
- generating a plasma in said vacuum chamber (10) by supplying electrical power to said cathodes (24, 26) such that said targets (28, 30) are sputtered,
- where electrical power is supplied to said first cathode (24) as pulsed electrical power according to high power impulse magnetron sputtering (HIPIMS) with a first peak current density,
- and where electrical power is supplied to said second cathode (26) as DC electrical power with a constant second current density or as time-variable electrical power with a second peak current density,
- where said second current density or said second peak current density is lower than said first peak current density,
- arranging said substrate (22) in said vacuum chamber (10), supplying a process gas and a reactive gas comprising Nitrogen to the vacuum chamber (10), and applying a bias voltage (V_{B}) to said substrate such that particles from said plasma deposit onto said substrate forming a coating,
- where said bias voltage (V_{B}) is applied comprising bias pulses (63), said bias pulses (63) being synchronized with said pulses (60) being applied to said first cathode (24), and being applied for a shorter pulse duration (T_{B}) than said pulses (60) applied to said first cathode,
**characterized in that**
the first material composition comprises as predominant metal element a processing metal element out of the group consisting of Hf, Ta, W, Zr, Nb and Mo, and
during deposition of said coating, the temperature of said substrate is less than 450 °C.

2. Process according to claim 1, where
- said duration (T_{B}) of said bias pulses (63) is 10-90% of a duration (T) of said pulses (60) applied to said first cathode,
- where said duration (T) of said pulses (60) applied to said first cathode (24) is defined as the duration during which the current (I_{M1}) is above 5% of the maximum current value.

3. Process according to one of the above claims, where
- during the application of HIPIMS pulses (60) to said first cathode (24) a metal-ion rich period (44) occurs during which said plasma comprises a substantial amount of metal ions,
- and where said bias pulses (63) are applied synchronously with at least a part of said metal-ion rich period (44).

4. Process according to one of the above claims, where
- said bias voltage (V_{B}) is applied as a DC voltage with superimposed bias voltage pulses (63),
- where said DC voltage has an absolute value of 10 - 80 V
- and where during said bias pulses (63) a bias voltage with an absolute value of 60-200V is applied.

5. Process according to one of the above claims, wherein
- said second material composition is comprised, except for unavoidable contaminations, of one of the combinations of metals chosen from the group comprising
- titanium,
- chromium,
- chromium and aluminum,
- titanium and aluminum,
- titanium, chromium and aluminium.

6. Process according to one of claims 1-4, wherein
- said second material composition is comprised, except for unavoidable contaminations, of one of the combinations of metals chosen from the group comprising
- titanium and boron
- titanium and silicon,
- titanium, aluminum and silicon,
- titanium, chromium, aluminum and silicon,
- chromium and silicon.

7. Process according to one of claims 1-4, wherein
- said second material composition is comprised, except for unavoidable contaminations, of carbon.

8. Process according to one of the above claims, where
- said electrical power is supplied to said first cathode (24) in pulses (60) such that a peak target current density is more than 0.12 A/cm²
- and said electrical power is supplied such that said second cathode (26) has a second current density or second peak target current density of less than 0.06 A/cm².

9. A device for coating a substrate (22), including
- a vacuum chamber (10),
- at least two magnetron cathodes (24, 26) arranged within said vacuum chamber (10),
- of which at least a first cathode (24) is provided with a sputtering target (28) of a first material composition comprising as predominant metal element a processing metal element out of the group comprising Hf, Ta, W, Zr, Nb and Mo,
- and a second material composition is provided as the material of one or more sputtering targets (30) mounted at least on a second cathode (26), said second material composition predominantly comprising one or more of the elements chosen from the group comprising C, Ti, Cr, Al, and Si, said one or more elements having a lower atomic mass than the metal of said first metal composition,
- power supplies (38, 40) connected to said first and second cathodes (24, 26) for applying electrical power to create a plasma for sputtering of said targets (28, 30),
- where a first electrical power supply (38) is connected to said first cathode (24), said first electrical power supply (38) being disposed to supply pulsed electrical power according to high power impulse magnetron sputtering (HIPIMS) with a first peak current density,
- and a second electrical power supply (40) is connected to said second cathode (26), said second electrical power supply (40) being disposed to supply electrical power to said second cathode (26) as DC electrical power with a constant second current density or as pulsed electrical power with a second peak current density,
- where said second current density or said second peak current density is lower than said first peak current density,
- a substrate holder (18, 20) arranged within said vacuum chamber (10) for holding said substrate (22),
- means (14, 16) for supplying a processing gas and a reactive gas comprising Nitrogen
- and a pulsed bias voltage supply (34) disposed to supply a bias voltage (V_{B}) to said substrate (22), said bias voltage (V_{B}) being a DC voltage with superimposed bias pulses (63), wherein said DC voltage has an absolute value of 10 - 80 V and wherein during said bias pulses (63) a bias voltage with an absolute value of 60-200V is applied,
- where a control unit is provided to synchronize at least said pulsed bias voltage supply (34) and said first electrical power supply (38) such that said bias pulses (63) are synchronized with said pulses (60) applied to said first cathode, and are applied to start with a delay after the start of said pulses (60) applied to said first cathode.

## Patentansprüche

1. Verfahren zur Beschichtung eines Substrats (22), umfassend
- Vorsehen von mindestens zwei Magnetron-Kathoden in einer Vakuumkammer (10),
- von denen mindestens eine erste Kathode (24) mit einem Sputtertarget (28) mit einer ersten Materialzusammensetzung versehen ist,
- und wobei eine zweite Materialzusammensetzung als das Material von mindestens einem Sputtertarget (30) an mindestens einer zweiten Kathode (26) vorgesehen ist, wobei die zweite Materialzusammensetzung vorwiegend eines oder mehrere der Elemente umfasst, die ausgewählt sind aus der Gruppe, die C, Ti, Cr, Al und Si umfasst, wobei das eine oder die mehreren Elemente eine geringere Atommasse als das Verarbeitungsmetallelement aufweisen,
- Erzeugen eines Plasmas in der Vakuumkammer (10) durch Zuführen von elektrischer Leistung zu den Kathoden (24, 26), sodass die Targets (28, 30) gesputtert werden,
- wobei die elektrische Leistung der ersten Kathode (24) als gepulste elektrische Leistung gemäß Hochleistungsimpulsmagnetronsputtem (HIPIMS) mit einer ersten Spitzenstromdichte zugeführt wird,
- und wobei elektrische Leistung der zweiten Kathode (26) als elektrische Gleichstromleistung mit einer konstanten zweiten Stromdichte oder als eine zeitvariable elektrische Leistung mit einer zweiten Spitzenstromdichte zugeführt wird,
- wobei die zweite Stromdichte oder die zweite Spitzenstromdichte geringer als die erste Spitzenstromdichte ist,
- Anordnen des Substrats (22) in der Vakuumkammer (10), Zuführen eines Prozessgases und einesreaktiven Gases, das Stickstoff umfasst, in die Vakuumkammer (10) und Anlegen einer Vorspannung (V_{B}) an das Substrat, sodass sich Teilchen aus dem Plasma auf das Substrat abscheiden und eine Beschichtung bilden,
- wobei die Vorspannung (V_{B}) mit Vorspannungsimpulsen (63) angelegt wird, wobei die Vorspannungsimpulse (63) mit den Impulsen (60), die an die erste Kathode (24) angelegt werden, synchronisiert sind und für eine geringere Impulsdauer (T_{B}) angelegt werden, als die Impulse (60), die an die erste Kathode angelegt werden,
**dadurch gekennzeichnet, dass**
die erste Materialzusammensetzung als vorwiegendes Metallelement ein Verarbeitungsmetallelement aus der Gruppe umfasst, die Hf, Ta, W, Zr, Nb und Mo umfasst, und
die Temperatur des Substrats, während der Abscheidung der Beschichtung, weniger als 450 °C beträgt.

2. Verfahren nach Anspruch 1, wobei
- die Dauer (T_{B}) der Vorspannungsimpulse (63) 10-90 % einer Dauer (T) der Impulse (60) beträgt, die an die erste Kathode angelegt werden,
- wobei die Dauer (T) der Impulse (60), die an die erste Kathode (24) angelegt werden, als die Dauer definiert ist, während der der Strom (I_{M1}) oberhalb von 5 % des maximalen Stromwerts liegt.

3. Verfahren nach einem der vorhergehenden Ansprüche, wobei
- während des Anlegens der HIPIMS-Impulse (60) an die erste Kathode (24) eine metallionenreiche Phase (44) eintritt, während der das Plasma eine erhebliche Menge an Metallionen umfasst,
- und wobei die Vorspannungsimpulse (63) synchron mit zumindest einem Teil der metallionenreichen Phase (44) angelegt werden.

4. Verfahren nach einem der vorhergehenden Ansprüche, wobei
- die Vorspannung (V_{B}) als eine Gleichspannung mit überlagerten Vorspannungsimpulsen (63) angelegt wird,
- wobei die Gleichspannung einen Absolutwert von 10-80 V aufweist,
- und wobei während der Vorspannungsimpulse (63) eine Vorspannung mit einem Absolutwert von 60-200 V angelegt wird.

5. Verfahren nach einem der vorhergehenden Ansprüche, wobei
- die zweite Materialzusammensetzung, abgesehen von unvermeidbaren Verunreinigungen, aus einer der Kombinationen von Metallen besteht, die aus der Gruppe ausgewählt sind, die Folgendes umfasst
- Titan,
- Chrom,
- Chrom und Aluminium,
- Titan und Aluminium,
- Titan, Chrom und Aluminium.

6. Verfahren nach einem der Ansprüche 1-4, wobei
- die zweite Materialzusammensetzung, abgesehen von unvermeidbaren Verunreinigungen, aus einer der Kombinationen von Metallen besteht, die aus der Gruppe ausgewählt sind, die Folgendes umfasst
- Titan und Bor,
- Titan und Silicium,
- Titan, Aluminium und Silicium,
- Titan, Chrom, Aluminium und Silicium,
- Chrom und Silicium.

7. Verfahren nach einem der Ansprüche 1-4, wobei
- die zweite Materialzusammensetzung, abgesehen von unvermeidbaren Verunreinigungen, aus Kohlenstoff besteht.

8. Verfahren nach einem der vorhergehenden Ansprüche, wobei
- die elektrische Leistung der ersten Kathode (24) in Impulsen (60) zugeführt wird, sodass eine Spitzentargetstromdichte mehr als 0,12 A/cm² beträgt,
- und die elektrische Leistung so zugeführt wird, dass die zweite Kathode (26) eine zweite Stromdichte oder eine zweite Spitzentargetstromdichte von weniger als 0,06 A/cm² aufweist.

9. Vorrichtung zur Beschichtung eines Substrats (22), umfassend
- eine Vakuumkammer (10),
- mindestens zwei Magnetron-Kathoden (24, 26), die in der Vakuumkammer (10) angeordnet sind,
- von denen mindestens eine erste Kathode (24) mit einem Sputtertarget (28) mit einer ersten Materialzusammensetzung versehen ist, die als vorwiegendes Metallelement ein Verarbeitungsmetallelement aus der Gruppe umfasst, die Hf, Ta, W, Zr, Nb und Mo umfasst,
- und wobei eine zweite Materialzusammensetzung als das Material von einem oder mehreren Sputtertargets (30), die zumindest an einer zweiten Kathode (26) angebracht sind, vorgesehen ist, wobei die zweite Materialzusammensetzung vorwiegend eines oder mehrere der Elemente umfasst, die ausgewählt sind aus der Gruppe, die C, Ti, Cr, Al und Si umfasst, wobei das eine oder die mehreren Elemente eine geringere Atommasse als das Metall mit der ersten Metallzusammensetzung aufweisen,
- Leistungsversorgungen (38, 40), die mit der ersten und der zweiten Kathode (24, 26) verbunden sind, um elektrische Leistung zum Erzeugen eines Plasmas zum Sputtern der Targets (28, 30) anzulegen,
- wobei eine erste elektrische Leistungsversorgung (38) mit der ersten Kathode (24) verbunden ist, wobei die erste elektrische Leistungsversorgung (38) so angeordnet ist, dass sie gepulste elektrische Leistung gemäß Hochleistungsimpulsmagnetronsputtem (HIPIMS) mit einer ersten Spitzenstromdichte zuführt,
- und wobei eine zweite elektrische Leistungsversorgung (40) mit der zweiten Kathode (26) verbunden ist, wobei die zweite elektrische Leistungsversorgung (40) so angeordnet ist, dass sie der zweiten Kathode (26) elektrische Leistung als elektrische Gleichstromleistung mit einer konstanten zweiten Stromdichte oder als gepulste elektrische Leistung mit einer zweiten Spitzenstromdichte zuführt,
- wobei die zweite Stromdichte oder die zweite Spitzenstromdichte geringer als die erste Spitzenstromdichte ist,
- einen Substrathalter (18, 20), der in der Vakuumkammer (10) angeordnet ist, um das Substrat (22) zu halten,
- Mittel (14, 16) zum Zuführen eines Prozessgases und eines reaktiven Gases, das Stickstoff umfasst,
- und eine gepulste Vorspannungsversorgung (34), die so angeordnet ist, dass sie dem Substrat (22) eine Vorspannung (V_{B}) zuführt, wobei die Vorspannung (V_{B}) eine Gleichspannung mit überlagerten Vorspannungsimpulsen (63) ist, wobei die Gleichspannung einen Absolutwert von 10-80 V aufweist, und wobei, während der Vorspannungsimpulse (63), eine Vorspannung mit einem Absolutwert von 60-200 V angelegt wird,
- wobei eine Steuereinheit vorgesehen ist, um zumindest die gepulste Vorspannungsversorgung (34) und die erste elektrische Leistungsversorgung (38) für elektrische Leistung zu synchronisieren, sodass die Vorspannungsimpulse (63) mit den Impulsen (60), die an die erste Kathode angelegt werden, synchronisiert werden und so angelegt werden, dass sie mit einer Verzögerung nach dem Beginn der Impulse (60), die an die erste Kathode angelegt werden, beginnen.

## Revendications

1. Processus pour revêtir un substrat (22), comportant
- la fourniture d'au moins deux cathodes au magnétron dans une chambre à vide (10),
- dont au moins une première cathode (24) est pourvue d'une cible (28) de pulvérisation d'une première composition de matériau,
- et où une seconde composition de matériau est prévue en tant que matériau d'au moins une cible (30) de pulvérisation à au moins une seconde cathode (26), ladite seconde composition de matériau comportant principalement un ou plusieurs des éléments choisis dans le groupe composé de C, Ti, Cr, Al et Si, lesdits un ou plusieurs éléments ayant une masse atomique inférieure à celle dudit élément métallique de traitement,
- la génération d'un plasma dans ladite chambre à vide (10) par fourniture d'énergie électrique auxdites cathodes (24, 26), de sorte que lesdites cibles (28, 30) soient pulvérisées,
- où l'énergie électrique est fournie à ladite première cathode (24) en tant qu'énergie électrique pulsée en fonction d'une pulvérisation à magnétron par impulsions à haute puissance (HIPIMS) avec une première densité de courant de crête,
- et où l'énergie électrique est fournie à ladite seconde cathode (26) en tant qu'énergie électrique CC avec une seconde densité de courant constante ou en tant qu'énergie électrique variable dans le temps avec une seconde densité de courant de crête,
- où ladite seconde densité de courant ou ladite seconde densité de courant de crête est inférieure à ladite première densité de courant de crête,
- l'agencement dudit substrat (22) dans ladite chambre à vide (10), la fourniture d'un gaz de procédé et d'un gaz réactif comportant de l'azote à la chambre à vide (10) et l'application d'une tension de polarisation (V_{B}) audit substrat, de sorte que des particules provenant dudit plasma se déposent sur ledit substrat formant un revêtement,
- où ladite tension de polarisation (V_{B}) est appliquée en comportant des impulsions de polarisation (63), lesdites impulsions de polarisation (63) étant synchronisées avec lesdites impulsions (60) appliquées à ladite première cathode (24) et étant appliquées pour une durée d'impulsion (T_{B}) plus courte que lesdites impulsions (60) appliquées à ladite première cathode,
**caractérisé en ce que**
la première composition de matériau comporte, en tant qu'élément métallique prédominant, un élément métallique de traitement parmi le groupe comportant Hf, Ta, W, Zr, Nb et Mo et
pendant le dépôt dudit revêtement, la température dudit substrat est inférieure à 450 °C.

2. Processus selon la revendication 1, où
- ladite durée (T_{B}) desdites impulsions de polarisation (63) est de 10 % à 90 % d'une durée (T) desdites impulsions (60) appliquées à ladite première cathode,
- où ladite durée (T) desdites impulsions (60) appliquées à ladite première cathode (24) est définie en tant que durée pendant laquelle le courant (I_{M1}) est au-dessus de 5 % de la valeur de courant maximum.

3. Processus selon l'une des revendications précédentes, où
- pendant l'application d'impulsions (60) HIPIMS à ladite première cathode (24), une période (44) riche en ions métalliques se produit, pendant laquelle ledit plasma comporte une quantité substantielle d'ions métalliques,
- et où lesdites impulsions de polarisation (63) sont appliquées de manière synchrone avec au moins une partie de ladite période (44) riche en ions métalliques.

4. Processus selon l'une des revendications précédentes, où
- ladite tension de polarisation (V_{B}) est appliquée en tant que tension CC avec des impulsions de tension de polarisation (63) superposées,
- où ladite tension CC a une valeur absolue de 10 V à 80 V
- et où, pendant lesdites impulsions de polarisation (63), une tension de polarisation avec une valeur absolue de 60 V à 200 V est appliquée.

5. Processus selon l'une des revendications précédentes, dans lequel
- ladite seconde composition de matériau est composée, à l'exception de contaminations inévitables, de l'une des combinaisons de métaux choisis parmi le groupe composé de
- titane,
- chrome,
- chrome et aluminium,
- titane et aluminium,
- titane, chrome et aluminium.

6. Processus selon l'une des revendications 1 à 4, dans lequel
- ladite seconde composition de matériau est composée, à l'exception de contaminations inévitables, de l'une des combinaisons de métaux choisis parmi le groupe composé de
- titane et bore
- titane et silicium,
- titane, aluminium et silicium,
- titane, chrome, aluminium et silicium,
- chrome et silicium.

7. Processus selon l'une des revendications 1 à 4, dans lequel
- ladite seconde composition de matériau est composée, à l'exception de contaminations inévitables, de carbone.

8. Processus selon l'une des revendications précédentes, où
- ladite énergie électrique est fournie à ladite première cathode (24) dans des impulsions (60), de sorte qu'une densité de courant cible de crête soit supérieure à 0,12 A/cm²
- et ladite énergie électrique est fournie, de sorte que ladite seconde cathode (26) ait une seconde densité de courant ou une seconde densité de courant cible de crête inférieure à 0,06 A/cm².

9. Dispositif pour revêtir un substrat (22), incluant
- une chambre à vide (10),
- au moins deux cathodes au magnétron (24, 26) agencées au sein de ladite chambre à vide (10),
- dont au moins une première cathode (24) est prévue avec une cible de pulvérisation (28) d'une première composition de matériau comportant, en tant qu'élément métallique prédominant, un élément métallique de traitement parmi le groupe comportant Hf, Ta, W, Zr, Nb et Mo
- et une seconde composition de matériau est prévue en tant que matériau d'une ou plusieurs cibles de pulvérisation (30) montées au moins sur une seconde cathode (26), ladite seconde composition de matériau comportant principalement un ou plusieurs des éléments choisis dans le groupe composé de C, Ti, Cr, Al et Si, lesdits un ou plusieurs éléments ayant une masse atomique inférieure à celle du métal de ladite première composition métallique,
- des alimentations électriques (38, 40) raccordées auxdites première et seconde cathodes (24, 26) pour appliquer une énergie électrique pour créer un plasma afin de pulvériser lesdites cibles (28, 30),
- où une première alimentation en énergie électrique (38) est raccordée à ladite première cathode (24), ladite première alimentation en énergie électrique (38) étant disposée pour fournir une énergie électrique pulsée selon une pulvérisation à magnétron par impulsions à haute puissance (HIPIMS) avec une première densité de courant de crête,
- et une seconde alimentation en énergie électrique (40) est raccordée à ladite seconde cathode (26), ladite seconde alimentation en énergie électrique (40) étant disposée pour fournir de l'énergie électrique à ladite seconde cathode (26) en tant qu'énergie électrique CC avec une seconde densité de courant constante ou en tant qu'énergie électrique pulsée avec une seconde densité de courant de crête,
- où ladite seconde densité de courant ou ladite seconde densité de courant de crête est inférieure à celle de ladite première densité de courant de crête,
- un support de substrat (18, 20) agencé au sein de ladite chambre à vide (10) pour maintenir ledit substrat (22),
- un moyen (14, 16) pour fournir un gaz de traitement et un gaz réactif comportant de l'azote
- et une alimentation en tension de polarisation pulsée (34) disposée pour fournir une tension de polarisation (V_{B}) audit substrat (22), ladite tension de polarisation (V_{B}) étant une tension CC avec des impulsions de polarisation (63) superposées, dans lequel ladite tension CC a une valeur absolue de 10 V à 80 V et dans lequel, pendant lesdites impulsions de polarisation (63), une tension de polarisation avec une valeur absolue de 60 V à 200 V est appliquée,
- où une unité de commande est prévue pour synchroniser au moins ladite alimentation en tension de polarisation pulsée (34) et ladite première alimentation en énergie électrique (38), de sorte que lesdites impulsions de polarisation (63) soient synchronisées avec lesdites impulsions (60) appliquées à ladite première cathode et soient appliquées pour commencer avec un retard après le début desdites impulsions (60) appliquées à ladite première cathode.
